# EUROPÄISCHE PATENTSCHRIFT

(11) **EP 1 012 620 B1**
(45) Veröffentlichungstag und Bekanntmachung des Hinweises auf die Patenterteilung: **04.12.2002**
(21) Anmeldenummer: 98948701.2
(22) Anmeldetag: 31.07.1998
(51) Int. Cl.: G01S 7/35, G01S 13/34, G01S 7/40, H03D 9/06

(54) **FMCW-SENSOR**
FMCW SENSOR
DETECTEUR A ONDES ENTRETENUES A MODULATION DE FREQUENCE (FMCW)

(30) Priorität: 27.08.1997 DE 19737385
(43) Veröffentlichungstag der Anmeldung: 28.06.2000
(73) Patentinhaber: SIEMENS AKTIENGESELLSCHAFT, 80333 München (DE)
(72) Erfinder: HEIDE, Patric, D-85579 Neubiberg (DE); NALEZINSKI, Martin, D-80803 München (DE)
(86) Internationale Anmeldenummer: DE9802198
(87) Internationale Veröffentlichungsnummer: WO99010756

(56) Entgegenhaltungen:
- FR-A- 2 552 270
- NALEZINSKI M ET AL: "NOVEL 24 GHZ FMCW FRONT-END WITH 2.45 GHZ SAW REFERENCE PATH FOR HIGH-PRECISION DISTANCE MEASUREMENTS" 1997 IEEE MTT-S INTERNATIONAL MICROWAVE SYMPOSIUM DIGEST, DENVER, JUNE 8 - 13, 1997, Bd. 1, 8. Juni 1997, Seiten 185-188, XP000767187 INSTITUTE OF ELECTRICAL AND ELECTRONICS ENGINEERS
- RIZZOLI V ET AL: "GENERAL-PURPOSE NOISE ANALYSIS OF FORCED NONLINEAR MICROWAVE CIRCUITS" PROCEEDINGS OF THE MM (MILLIMETRE) CONFERENCE, BRIGHTON, OCT. 14 - 15, 1992, Nr. CONF. 9, 14. Oktober 1992, Seiten 293-298, XP000308241 MICROWAVE EXHIBITIONS AND PUBLISHERS
- MINAKAWA A ET AL: "A MILLIMETER-WAVE BAND MMIC DUAL-QUADRATURE UP-CONVERTER USING MULTILAYER DIRECTIONAL COUPLERS" IEEE TRANSACTIONS ON MICROWAVE THEORY AND TECHNIQUES, Bd. 45, Nr. 1, Januar 1997, Seiten 78-82, XP000642637
- KRUGER D A: "MONOLITHIC DUAL-QUADRATURE MIXER USING GAAS FETS" MICROWAVE JOURNAL, Bd. 33, Nr. 9, 1. September 1990, Seiten 201, 202, 204-206, XP000168023

## Beschreibung

Bei Sensorsystemen mit FMCW-Radar, insbesondere Mikrowellenradarsystemen besteht die Möglichkeit einer simultanen Abstands- und Geschwindigkeitsmessung. Derartige Sensorsysteme besitzen vielfältige Anwendungsmöglichkeiten z. B. in der Automobil- oder Automatisierungstechnik. Die Abkürzung FM steht für Frequenzmodulation und CW für Continuous Wave. Eine Signalquelle erzeugt ein sich wellenförmig ausbreitendes, frequenzmoduliertes Signal. Die Signalquelle umfaßt z. B. einen Mikrowellenoszillator und einen Modulator. Das vorzugsweise linear frequenzmodulierte Signal wird von einer Antenne abgestrahlt und von einem Meßobjekt reflektiert. Das empfangene Signal wird in einem Mischer mit dem gerade vorhandenen Sendesignal gemischt. Die sich ergebende Differenzfrequenz ist ein Maß für den Abstand des Meßobjektes von der Antenne. Für die Sende- und Empfangseinrichtung kann eine monostatische oder eine bistatische Antennenanordnung verwendet werden. Bei der monostatischen Anordnung werden das Sende- und das Empfangssighal von der gemeinsamen Sende- und Empfangsantenne abgestrahlt bzw. empfangen. Durch einen Zirkulator oder Richtkoppler werden das Sende- und das Empfangssignal voneinander getrennt, d. h. das Sendesignal wird von dem Empfangsmischer getrennt, und das Empfangssignal wird vom Sendepfad getrennt. Bei der bistatischen Antennenanordnung sind gesonderte Sende- und Empfangsantennen vorgesehen.

In der WO 97/09637 ist ein FMCW-Radarsensor beschrieben, bei dem eine Verzögerungsleitung als Referenzeinrichtung vorhanden ist. Mit dieser Referenzeinrichtung wird ein zeitlich verzögertes Signal aus dem Sendesignal erzeugt, mit dem ein Abgleich und eine Korrektur eines Meßsignales so vorgenommen werden können, daß ein nichtlinearer Verlauf der Kennlinie der Modulation damit rechnerisch kompensiert werden kann. Eine Korrektur der Modulationskennlinie aufgrund einer Auswertung des Referenzsignales ist ebenfalls möglich. Eine einem ähnlichen Zweck dienende Vorrichtung ist in der WO 97/09777 beschrieben.

Weitere Beispiele zur Linearisierung der Modulation bei FMCW-Sensoren findet man in den Veröffentlichungen von B. Zimmermann et al.: "24 GHz Microwave Close-Range Sensors For Industrial Measurement Applications" in Microwave Journal, Mai 1996, Seiten 228 bis 238, und von P. Lowbridge et al.: A Low Cost mm-Wave Cruise Control System for Automotive Applications" in Microwave Journal, Oktober 1993, Seiten 24 bis 36. Es wird eine geschlossene Regelschleife, beispielsweise mit digitalem Frequenzdiskriminator, verwendet, die mit einem Zwischenfrequenzsignal gespeist wird. Dafür ist ein zusätzlicher frequenzstabiler Lokaloszillator erforderlich. Als Alternative dazu ist in US 5,546,088 ein Radarsensor beschrieben, bei dem ein frequenzmoduliertes 24 GHz-Radarsignal durch Frequenzverfünffachung eines 4,8 GHz-VCO-Signals erzeugt wird. Dafür ist allerdings ein erheblicher Schaltungsaufwand erforderlich.

Nachteilig bei bekannten FMCW-Sensoren ist weiterhin, daß bei bistatischem Aufbau getrennte Sende- und Empfangseinrichtungen vorhanden sein müssen und bei monostatischem Aufbau ein Zirkulator oder Hybridkoppler bzw. Richtkoppler zur Aufteilung von Sende- und Empfangssignalen auf die verschiedenen Signalwege erforderlich ist. In der DE 196 10 850 C1 ist ein monostatisches homodynes Radarsystem beschrieben, bei dem ein balancierter Mischer (Gegentaktmischer) anstelle eines herkömmlichen Richtkopplers mit separatem Mischer eingesetzt wird. Der Mischer enthält einen als Richtkoppler fungierenden Hybridkoppler mit 90° Phasendifferenz zwischen den Koppelarmen und weist einen Reflexionsfaktor von mehr als 0,3 auf, so daß eine für die Abstrahlung des Sendesignales ausreichende Überkopplung der von dem Oszillator gelieferten Leistung zur Antenne erfolgt.

In der WO 95/26073 ist ein Hochfrequenzoszillator in Planarbauweise beschrieben, bei dem ein dielektrischer Resonator in höheren Moden betrieben wird und durch geeignete Ausrichtung an einen Mikrostreifenleiter angekoppelt wird. Ein solcher Oszillator im Bereich um 24 GHz ist als Signalquelle für FMCW-Sensoren geeignet.

Aufgabe der vorliegende Erfindung ist es, einen FMCW-Sensor, insbesondere zur Abstandsmessung, anzugeben, der bei vermindertem Herstellungsaufwand präzise Meßergebnisse liefert.

Diese Aufgabe wird mit dem FMCW-Sensor mit den Merkmalen des Anspruches 1 gelöst. Ausgestaltungen ergeben sich aus den abhängigen Ansprüchen.

Der erfindungsgemäße Sensor verfügt über Komponenten, die eine genaue Messung garantieren, aber so ausgestaltet sind, daß der Aufwand bei der Herstellung des Sensors gering bleibt. Die dafür eingesetzten Mittel sind nicht alle notwendig. Ein bevorzugtes Ausführungsbeispiel ergibt sich aber aus einer Kombination aller im folgenden angegebenen Verbesserungen. Der erfindungsgemäße Sensor ist für die Realisierung als hybride planare Schaltung (z. B. in Mikrostreifenleitungstechnik oder Koplanartechnik) besonders geeignet.

Bei dem Sensor wird eine Referenzeinrichtung verwendet, die eine Verzögerungsleitung umfaßt. Damit kann die Nichtlinearität der Modulationskennlinie rechnerisch oder durch eine entsprechende Vorverzerrung des Modulators korrigiert werden. Das Referenzsignal wird dadurch gewonnen, daß ein moduliertes, vergleichsweise niederfrequentes Signal zeitverzögert wird und mit dem unverzögerten Signal gemischt wird. Das modulierte niederfrequente Signal wird erfindungsgemäß von einem dafür geeigneten Frequenzgenerator (Oszillator) geliefert. Da als Sendesignal ein hochfrequentes moduliertes Signal gefordert wird, wird das niederfrequente modulierte Signal durch Mischen mit einem festen hochfrequenten Signal zu einem hochfrequenten modulierten Signal umgesetzt. Daher ist erfindungsgemäß nur ein Frequenzgenerator, der ein Signal hoher fester Frequenz liefert, aber kein hochfrequent modulierbarer Oszillator erforderlich. Als Festfrequenzgenerator für hohe Frequenz eignet sich insbesondere ein Oszillator, der mit einem dielektrischen Resonator aufgebaut ist entsprechend der zitierten WO 95/26073. Mit dielektrisch stabilisierten Festfrequenzoszillatoren lassen sich die technischen Anforderungen hinsichtlich Temperaturstabilität, Ausgangsleistung, Mittenfrequenz-Reproduzierbarkeit und Phasenrauschen erfüllen.

Eine weitere Vereinfachung des technischen Aufwandes kann bei dem erfindungsgemäßen Sensor dadurch erreicht werden, daß ein monostatisches Sende- und Empfangssystem verwendet wird, das eine Trennung von Sende- und Empfangssignal nicht durch einen herkömmlichen Zirkulator oder Richtkoppler erreicht, sondern einen in Transmission betriebenen speziellen Mischer verwendet, so daß auf eine besondere Trennung von Sende- und Empfangssignal verzichtet werden kann.

Die Bauelemente mit nichtlinearer Kennlinie der in dem Sensor eingesetzten Mischer können durch Verwendung geeigneter handelsüblicher Feldeffekttransistoren an Stelle von Dioden vergleichsweise billig hergestellt werden.

Es folgt eine genauere Beschreibung bevorzugter Ausführungsformen anhand der beigefügten Figuren.
Figur 1 zeigt ein Blockschaltbild für eine bevorzugte Ausführungsform.
Figuren 2 bis 6 zeigen Blockschaltbilder für verschiedene Ausgestaltungen eines verwendeten Mischers.
Figur 7 zeigt ein Blockschaltbild für eine alternative Ausführungsform der Anordnung gemäß Figur 1.
Figur 8 zeigt ein Blockschaltbild eines nach der Phasenmethode arbeitenden Mischers.
Figur 9 zeigt ein Blockschaltbild für eine bevorzugte Ausführung des Sende-/Empfangsmischers.
Figur 10 zeigt einen Feldeffekttransistor mit kurzgeschlossenen Anschlüssen von Source und Drain und ein Ersatzschaltbild dieses Transistors als Diode.

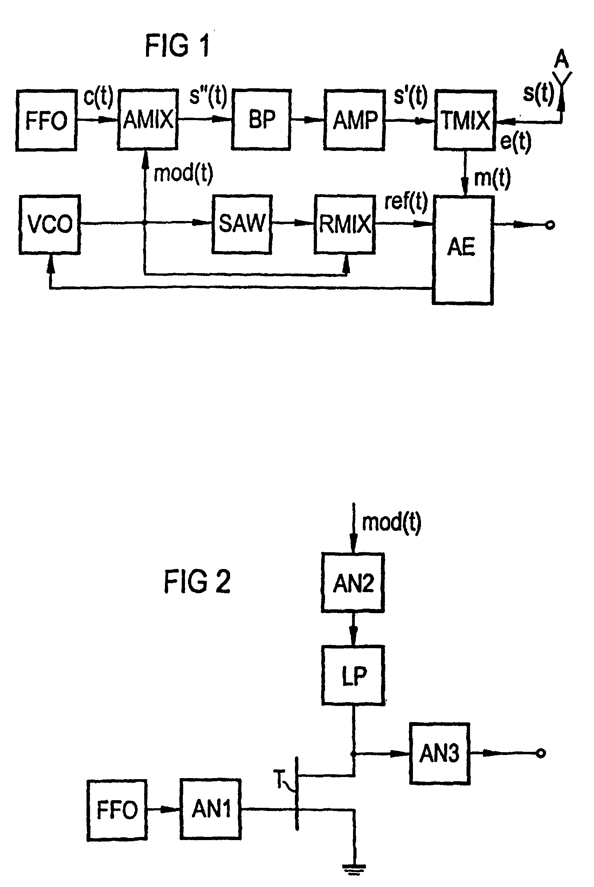

Ein Sensor, der im Prinzip nach dem Blockschaltbild der Figur 1 aufgebaut ist, benötigt nur einen Hochfrequenzoszillator, der nicht moduliert zu werden braucht. Zu diesem Zweck kann ein Festfrequenzoszillator FFO ("Lokaloszillator") vorgesehen sein, der an einen Mischer AMIX angeschlossen wird.

In diesem Mischer wird das hochfrequente Ausgangssignal des Festfrequenzoszillators mit einer niedrigeren und modulierten Frequenz gemischt, die der zweite Oszillator, in diesem Beispiel ein spannungsgesteuerter Oszillator VCO, liefert. Das frequenzmodulierte Signal mod(t) moduliert das an AMIX anliegende hochfrequente Trägersignal c(t), so daß AMIX ein Signal s'' (t) liefert, das spektral aus dem frequenzmodulierten Signal mod(t), aus dem Trägersignal c(t) und den beiden resultierenden Seitenbändern besteht. Die Frequenz des Festfrequenzoszillators FFO ist z. B. 21,7 GHz. Der zweite Oszillator VCO erzeugt ein frequenzmoduliertes Signal mit einer Mittenfrequenz von z. B. 2,4 GHz. Bei der Wahl von 2,4 GHz als Mittenfrequenz des frequenzmodulierten Signals kann die Oberflächenwellen-Verzögerungsleitung der Referenzeinrichtung noch verwendet werden, obwohl die Technik der Oberflächenwellenbauelemente bei steigenden Frequenzen an die technischen Grenzen stößt. Der Abstand der Seitenbänder ist gleichwohl ausreichend groß, um die Trägerfrequenz im Sendespektrum wirksam unterdrücken zu können. Das gemischte Signal am Ausgang des Mischers AMIX besitzt außer der Trägerfrequenz ein unteres und ein oberes Seitenband im Abstand von 2,4 GHz.

Der Mischer AMIX kann mit einem Feldeffekttransistors aufgebaut sein. Ein zugehöriges Ausführungsbeispiel des Mischers ist in Figur 2 im Blockschaltbild dargestellt. In Figur 2 ist der linke obere Teil des Blockschaltbildes von Figur 1 für die Verwendung eines Feldeffekttransistors als Mischer gezeichnet. Der Festfrequenzoszillator FFO ist über ein Anpassungsnetzwerk AN1 an den Gate-Anschluß eines Feldeffekttransistors T geführt. Vorzugsweise wird dafür ein HEMT (high electron mobility transistor) verwendet. Das modulierte Signal mod(t) von dem zweiten Oszillator wird vorzugsweise über ein weiteres Anpassungsnetzwerk AN2 und ein Tiefpaßfilter LP zum Drain-Anschluß des Transistors geführt. Der Source-Anschluß liegt auf Masse. Am Drain-Anschluß kann, vorzugsweise wieder über ein Anpassungsnetzwerk AN3, das multiplizierte Signal abgegriffen und den weiteren Komponenten (Frequenzfilter BP) zugeführt werden.

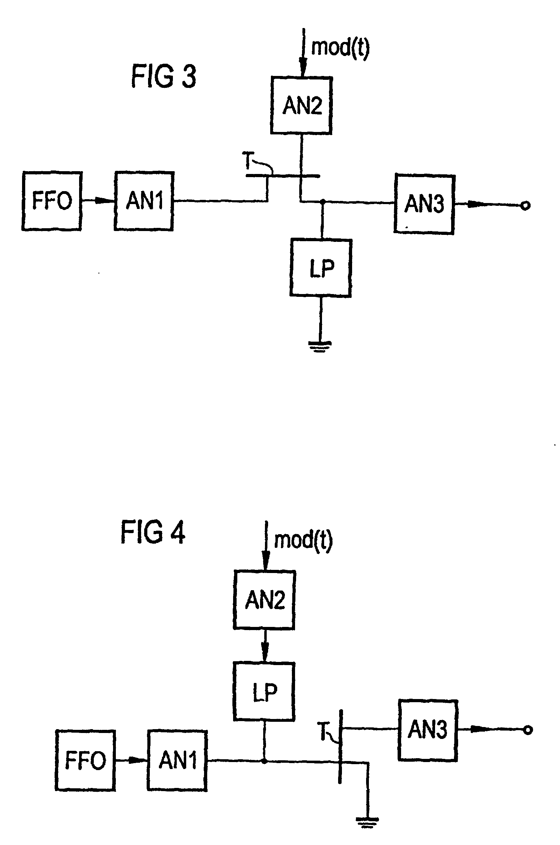

Figur 3 zeigt eine Alternative zu der Schaltung der Figur 2. Das frequenzmodulierte Signal mod(t) wird hier über ein Anpassungsnetzwerk AN2 an das Gate des Transistors geführt, während das vom Festfrequenzoszillator FFO kommende Trägersignal c(t) über das erste Anpassungsnetzwerk AN1, Drain, Source und das Anpassungsnetzwerk AN3 im Ausgang zu dem Signal s'' (t) gemischt wird. Ein Tiefpaßfilter LP im Ausgang schließt tieffrequente Anteile gegen Masse kurz.

Figur 4 zeigt ebenfalls eine Alternative zu der Schaltung der Figur 2. Das vom Festfrequenzoszillator FFO kommende Trägersignal c(t) gelangt über das erste Anpassungsnetzwerk AN1 und das frequenzmodulierte Signal mod(t) gelangt über das zweite Anpassungsnetzwerk AN2 und ein Tiefpaßfilter LP jeweils an das Gate des Transistors T. Source liegt an Masse, und vom Drain des Transistors wird über ein drittes Anpassungsnetzwerk AN3 das Signal s''(t) abgegriffen.

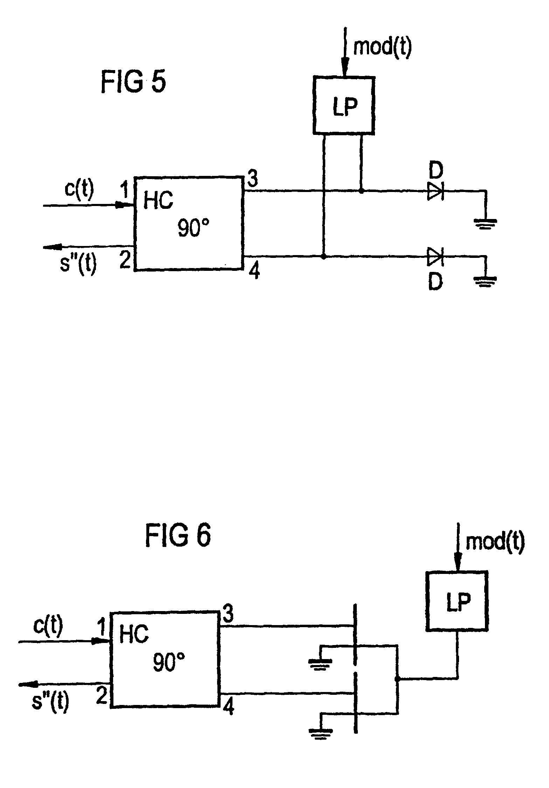

Figur 5 zeigt eine andere Ausgestaltung des Mischers AMIX, bei der ein Hybridkoppler mit 90° Phasenverschiebung zwischen den Koppelarmen verwendet wird. An einem Eingang 1 des Hybridkopplers liegt das vom Festfrequenzoszillator FFO kommende Trägersignal c(t) an; an die Ausgänge 3, 4 des Hybridkopplers, die über Dioden gegen Masse abgeschlossen sind, wird über ein Tiefpaßfilter LP das modulierte Signal mod(t) vom zweiten Oszillator VCO geführt. Die Dioden werden durch das modulierte Signal mod(t) zwischen leitendem und sperrendem Zustand wie Schalter umgeschaltet. Dadurch entsteht ein phasenmoduliertes Signal, das an dem zweiten Eingang 2 des Hybridkopplers (Ausgang von AMIX in dieser Variante) als Signal s''(t) abgegriffen werden kann.

Figur 6 zeigt die Anordnung von Figur 5, bei der die Dioden durch Feldeffekttransistoren ersetzt sind. Die Drain-Anschlüsse der Transistoren sind mit den Ausgängen 3, 4 des Hybridkopplers verbunden. Die Source-Anschlüsse liegen auf Masse. An die Gate-Anschlüsse ist über ein Tiefpaßfilter LP das vom zweiten Oszillator VCO kommende modulierte Signal mod(t) angelegt.

Ein dem Mischer AMIX nachgeschaltetes Frequenzfilter BP filtert das obere Seitenband bei 24,1 GHz aus, d. h. daß dieses Seitenband durchgelassen wird. Das Trägersignal von 21,7 GHz und das untere Seitenband von 19,3 GHz werden unterdrückt. Alternativ kann das untere Seitenband ausgefiltert werden. Wenn man eine Trägerfrequenz von 26,5 GHz wählt, liegt das untere Seitenband ebenfalls bei der vorgesehenen Frequenz von 24,1 GHz. Durch die besondere Ausführungsform des Bandpaßfilters kann die notwendige Unterdrückung der Trägerfrequenz und vorhandener unerwünschter Nebenfrequenzen erreicht werden. Eine bevorzugte Ausführungsform des Filters umfaßt ein besonders dünnes Substrat von z. B. etwa 127 µm Dicke und HFabsorbierendes Material in geringem Abstand zu einer als Streifenleitung ausgebildeten Filterstruktur. Das HFabsorbierende Material ist einseitig oder beidseitig parallel neben der Filterstruktur, ggf. auch darüber, angebracht.

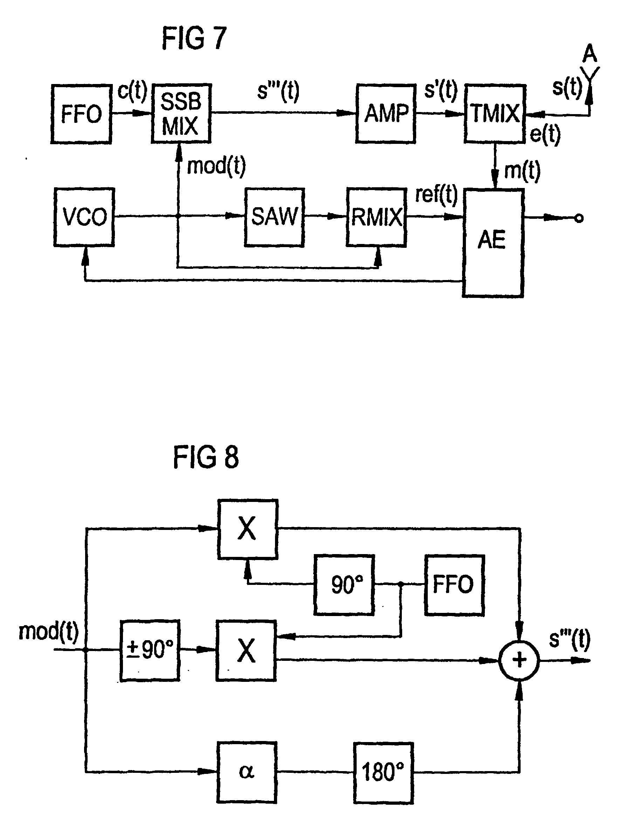

Statt der bisher beschriebenen Ausführung des Filters AMIX kann das obere Seitenband der gemischten Frequenzen auch nach der an sich bekannten sogenannten Phasenmethode erzeugt werden (s. z. B. Meinke/Gundlach, Taschenbuch der Hochfrequenztechnik, 5. Aufl., Springer-Verlag, Berlin/Heidelberg 1992, S. O 4 bis O 6). Bei der Phasenmethode werden beim Mischen mehrere Teilsignale erzeugt, und durch Überlagerung dieser Teilsignale mit geeigneten Phasenverschiebungen relativ zueinander wird eine Auslöschung des unteren Seitenbandes und des Trägersignales sowie eine konstruktive Überlagerung des oberen Seitenbandes herbeigeführt. Ein dafür geeigneter Mischer SSBMIX ersetzt entsprechend der Darstellung in Figur 7 den Mischer AMIX und den Bandpaßfilter BP. Der Mischer SSBMIX kann dabei z. B. die in Figur 8 als Blockschaltbild gezeigte übliche Anordnung eines Einseitenbandmischers besitzen.

Fakultativ ist ein Verstärker AMP (s. Figur 1 bzw. Figur 7) vorhanden, in dem das 24,1 GHz-Signal verstärkt wird. Die besonderen Ausführungsformen des Mischers AMIX bzw. SSBMIX reduzieren die Umsetzungsverluste, so daß auf eine anschließende Verstärkung entweder ganz verzichtet werden kann oder nur ein einstufiger Verstärker verwendet werden muß, um den optimalen Arbeitspunkt des Sende- und Empfangsmischers zu erreichen. Hierdurch wird die praktische Realisierung des Gesamtsystems nennenswert vereinfacht. Schließlich wird das Signal der Sende-/Empfangseinrichtung zugeführt. Das Bandpaßfilter BP kann bei anderen Ausführungsformen direkt vor der Antenne angeordnet sein oder zwischen dem Verstärker und der Sende/Empfangseinrichtung.

Das von dem zweiten Oszillator VCO gelieferte modulierte niederfrequente Signal von 2,4 GHz in diesem Beispiel wird auch auf den Eingang einer Referenzeinrichtung gegeben. Diese Referenzeinrichtung verfügt über eine Verzögerungsleitung, mit der das eingespeiste Signal zeitverzögert wird. Dafür ist z. B. insbesondere ein Oberflächenwellenbauelement SAW geeignet. Das zeitverzögerte Signal wird in einem weiteren Mischer RMIX mit dem ursprünglichen Signal des zweiten Oszillators zu einem Referenzsignal ref(t) gemischt.

Die Sende-/Empfangseinrichtung ist als monostatisches System ausgebildet. Es ist ein Sende-/Empfangsmischer TMIX vorhanden, dem das (ggf. von dem Verstärker AMP verstärkte) Sendesignal s'(t) zugeführt wird. Dieser Sende-/Empfangsmischer leitet das Sendesignal s(t) zur Antenne A weiter. Das empfangene Signal e(t) gelangt wieder in den Sende-/Empfangsmischer und wird dort mit dem Sendesignal demoduliert und als Meßsignal m(t) einer Auswerteeinrichtung AE zugeführt.

In diese Auswerteeinrichtung gelangt ebenfalls das Referenzsignal ref(t). Eine mögliche Ausgestaltung sieht vor, über einen Vergleich des Meßsignales m(t) mit dem Referenzsignal ref(t) eine geeignete Korrektur für die Modulation des zweiten Oszillators VCO zu gewinnen.

Die Auswertung der Sensorsignale findet innerhalb der Auswerteeinrichtung AE statt. Diese Einheit hat außerdem die Aufgabe, die in der Praxis auftretenden Phasenfehler der Modulation zu korrigieren. Das kann nachträglich rechnerisch durch eine Korrektur des Meßsignales erfolgen. Alternativ ist, ggf. auch zusätzlich, eine Vorverzerrung der Modulationskennlinie im zweiten Oszillator VCO vorgesehen. Die Modulation dieses zweiten Oszillators wird dann dahingehend verzerrt, daß am Ausgang des Oszillators ein moduliertes Signal mit linearer Frequenzänderung erzeugt wird. Jeweils noch vorhandene Phasenfehler werden durch Verwendung der Referenzeinrichtung erfaßt und eine entsprechende Korrektur des Meßsignales und/oder der Modulation daraus abgeleitet. Dafür geeignete Vorrichtungen sind z. B. wie eingangs zitiert in der WO 97/09637 und in der WO 97/09777 beschrieben.

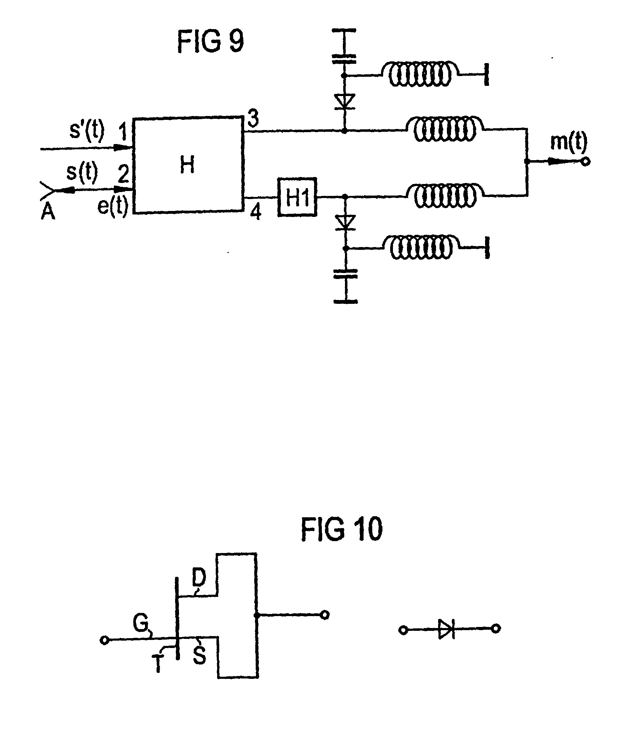

Figur 9 zeigt eine Ausgestaltung eines in der Sende/Empfangseinrichtung eingesetzten balancierten Mischers. Es handelt sich um einen Transmissionsmischer, der einen Hybridkoppler und Dioden oder andere nichtlineare Bauelemente umfaßt und der einen Anteil des an einem Eingang eingespeisten Signales den Hybridkoppler zum anderen Eingang hin passieren läßt. Die Phasendifferenz zwischen den beiden Koppelarmen des Hybridkopplers beträgt 90°. Der Mischer ist so konzipiert, daß die Koppelarme durch gleiche Lastimpedanzen mit einem so deutlich über 0 liegenden Reflexionsfaktor abgeschlossen sind, daß ein ausreichender Anteil der von dem Oszillator bereitgestellten Leistung auf das andere Eingangstor des Mischers überkoppelt und für das Abstrahlen zur Verfügung steht. Die durch das Mischen des Signales s'(t) und eines Empfangssignales e(t) (Figur 1 bzw. Figur 7) erzeugte Zwischenfrequenz kann an einem Ausgangstor des Mischers als Meßsignal m(t) abgegriffen werden.

In der Figur 9 ist ein Hybridkoppler H eingezeichnet mit vier Anschlußtoren. An einem Eingangstor 1 liegt das ankommende Signal s'(t) an. Das andere Eingangstor 2 ist mit der Antenne A verbunden, so daß dort das Sendesignal s(t) den Hybridkoppler verläßt und das Empfangssignal e(t) in den Hybridkoppler gelangt. Gegenüber balancierten Mischern üblicher Bauart wird bei diesem Mischer keine möglichst gute Entkopplung aller Tore angestrebt. Das hätte nämlich bei der Anordnung nach Figur 1 zur Folge, daß keine Abstrahlung über die Antenne erfolgt, weil die gesamte von dem Oszillator zum Eingangstor 1 des Mischers gelangende Leistung im Mischer absorbiert würde. Der hier verwendete Transmissionsmischer ist daher so beschaffen, daß ein definierter Teil der Leistung des von dem Oszillator gelieferten Hochfreguenzsignales zum anderen Eingangstor 2 des Mischers überkoppelt und auf diesem Weg zur Antenne gelangt. Es sind daher keine weiteren Bauelemente oder Baugruppen erforderlich, um den Sende-/Empfangsmischer zu realisieren.

Die in Figur 9 eingezeichneten Dioden sind als Beispiel gegensinnig zueinander angeordnet. Die Dioden können statt dessen gleichsinnig zueinander angeordnet sein oder z. B. auch jeweils in Reihe zwischen ein Ausgangstor 3, 4 des Hybridkopplers und den Ausgang des Transmissionsmischers, der an die Auswerteeinrichtung AE geführt ist, geschaltet sein, wie das in der zitierten DE 196 10 850 C1 angegeben ist. An die Ausgänge 3, 4 des Hybridkopplers gelangen Linearkombinationen der an den Eingängen 1, 2 des Hybridkopplers anliegenden Signale. Wegen der nichtlinearen Kennlinien erzeugen die Dioden Signale unter anderem bei der Differenzfrequenz, die über die weiteren als Beispiel eingezeichneten Schaltungskomponenten, die aber entsprechend den jeweiligen Ausführungsbeispielen abgewandelt werden können, als Meßsignal an den Ausgang gelangt. Von dort wird das Meßsignal m(t) an die Auswerteeinrichtung AE geführt. Der gewünschte Reflexionsfaktor ergibt sich entweder aufgrund der Impedanz der vorhandenen Dioden unmittelbar, oder es werden geeignete Mittel eingesetzt, wie z. B. Transformationsnetzwerke in dem Hybridkoppler oder eine geeignet an die Dioden angelegte Gleichspannung. Es ist auch möglich, einen Hybridkoppler mit einer Phasendifferenz von 180° zwischen den Koppelarmen zu verwenden, wenn an ein Ausgangstor 4 des Hybridkopplers zusätzlich ein Schaltungselement H1 eingebaut wird, das die Phase um 90° verschiebt. Dieses in Figur 9 eingezeichnete Schaltungselement H1 kann entfallen, wenn der Hybridkoppler bereits die gewünschte Phasendifferenz von 90° aufweist. Grundsätzlich kann als Sende/Empfangsmischer TMIX ein beliebiger Vierpol verwendet werden, bei dem ein Tor von den Eingangstoren isoliert ist und die an einem Eingangstor eingespeiste Leistung auf die verbleibenden zwei Tore symmetrisch aufgeteilt wird.

Statt der Dioden sind andere Halbleiterbauelemente, die nichtlineare Kennlinien aufweisen, in der Anordnung verwendbar. Es kann z. B. ein Feldeffekttransistor, vorzugsweise ein HEMT, bei dem der Source-Anschluß S und der Drain-Anschluß D wie in Figur 10 eingezeichnet kurzgeschlossen sind, verwendet werden. Die Strecke vom Gate-Anschluß zu dem gemeinsamen Anschluß von Source und Drain bildet dann eine Diode entsprechend dem in Figur 10 rechts eingezeichneten Ersatzschaltbild. Die Polung der Diode hängt grundsätzlich vom gewählten Typ des Transistors ab, entspricht jedoch bei einem PHEMT der in Figur 10 dargestellten Polung.

## Patentansprüche

1. FMCW-Sensor mit einem Festfrequenzgenerator (FFO), der zur Erzeugung einer Trägerfrequenz vorgesehen ist, und mit einem zweiten Frequenzgenerator (VCO), der zur Erzeugung veränderbarer Modulationsfrequenzen vorgesehen ist,
- bei dem ein Mischer (AMIX) in Form eines Feldeffekttransistors mit einem Gate-Anschluß, einem Source-Anschluß und einem Drain-Anschluß vorhanden ist, und der dafür vorgesehen ist, Mischsignale aus der Trägerfrequenz und den Modulationsfrequenzen zu erzeugen, wobei
der Gate-Anschluß an den Festfrequenzgenerator angeschlossen ist,
der Drain-Anschluß an den zweiten Frequenzgenerator angeschlossen ist,
der Source-Anschluß mit Masse verbunden ist,
ein Mischsignal vom Drain-Anschluß zu einem Ausgang geführt ist,
- bei dem der Mischer dafür vorgesehen ist oder ein nachgeschaltetes Frequenzfilter (BP) vorhanden und dafür vorgesehen ist, die erzeugten Mischsignale auf ein vorgegebenes Frequenzband zu reduzieren,
- bei dem eine Sende- und Empfangseinrichtung (TMIX, A) vorhanden ist,
- bei dem eine Referenzeinrichtung (SAW, RMIX) vorhanden ist, die an den zweiten Frequenzgenerator angeschlossen ist,
- bei dem eine Auswerteeinrichtung (AE) vorhanden ist und
- bei dem diese Auswerteeinrichtung an die Sende- und Empfangseinrichtung und an die Referenzeinrichtung angeschlossen ist.

2. FMCW-Sensor mit einem Festfrequenzgenerator (FFO), der zur Erzeugung einer Trägerfrequenz vorgesehen ist, und mit einem zweiten Frequenzgenerator (VCO), der zur Erzeugung veränderbarer Modulationsfrequenzen vorgesehen ist,
- bei dem ein Mischer (AMIX) in Form eines Feldeffekttransistors mit einem Gate-Anschluß, einem Source-Anschluß und einem Drain-Anschluß vorhanden ist, und der dafür vorgesehen ist, Mischsignale aus der Trägerfrequenz und den Modulationsfrequenzen zu erzeugen, wobei
der Drain-Anschluß an den Festfrequenzgenerator angeschlossen ist,
der Gate-Anschluß an den zweiten Frequenzgenerator angeschlossen ist,
der Source-Anschluß über ein Tiefpaßfilter mit Masse verbunden ist,
ein Mischsignal vom Source-Anschluß zu einem Ausgang geführt ist,
- bei dem der Mischer dafür vorgesehen ist oder ein nachgeschaltetes Frequenzfilter (BP) vorhanden und dafür vorgesehen ist, die erzeugten Mischsignale auf ein vorgegebenes Frequenzband zu reduzieren,
- bei dem eine Sende- und Empfangseinrichtung (TMIX, A) vorhanden ist,
- bei dem eine Referenzeinrichtung (SAW, RMIX) vorhanden ist, die an den zweiten Frequenzgenerator angeschlossen ist,
- bei dem eine Auswerteeinrichtung (AE) vorhanden ist und
- bei dem diese Auswerteeinrichtung an die Sende- und Empfangseinrichtung und an die Referenzeinrichtung angeschlossen ist.

3. FMCW-Sensor nach einem der Ansprüche 1 oder 2,
bei dem der Feldeffekttransistor ein HEMT (high electron mobility transistor) ist.

4. FMCW-Sensor nach einem der Ansprüche 1 bis 3,
- bei dem die Sende- und Empfangseinrichtung für monostatischen Betrieb vorgesehen ist und einen Transmissionsmischer (TMIX) und eine Antenne (A) umfaßt,
- bei dem der Transmissionsmischer einen Hybridkoppler mit einer Phasendifferenz von 90° in den Koppelarmen oder einen Hybridkoppler mit einer Phasendifferenz von 180° in den Koppelarmen zusammen mit einem Schaltungselement, das eine Phasenverschiebung um 90° bewirkt und das in einem der Koppelarme angeordnet ist, umfaßt,
- bei dem die Ausgänge (3, 4) des Hybridkopplers mit nichtlinearen Bauelementen abgeschlossen sind,
- bei dem ein Eingangstor (1) des Transmissionsmischers direkt oder über weitere Schaltungselemente an den Mischer (AMIX, SSBMIX) angeschlossen ist,
- bei dem das andere Eingangstor (2) des Transmissionsmischers an eine Antenne angeschlossen ist und
- bei dem die Auswerteeinrichtung an ein Ausgangstor des Transmissionsmischers angeschlossen ist.

5. FMCW-Sensor nach Anspruch 4,
bei dem die nichtlinearen Bauelemente Feldeffekttransistoren sind, deren Source-Anschluß jeweils mit dem Drain-Anschluß elektrisch leitend verbunden ist.

6. FMCW-Sensor nach einem der Ansprüche 1 bis 5,
bei dem die Referenzeinrichtung eine Verzögerungsleitung ist, die dafür vorgesehen ist, ein gegenüber dem Sendesignal zeitverzögertes Referenzsignal zu erzeugen.

7. FMCW-Sensor nach Anspruch 6,
bei dem die Referenzeinrichtung ein Oberflächenwellenbauelement (SAW) und einen weiteren Mischer (RMIX) umfaßt.

## Claims

1. FMCW sensor having a fixed frequency generator (FFO) which is provided for producing a carrier frequency, and having a second frequency generator (VCO) which is provided for producing variable modulation frequencies,
- in which a mixer (AMIX) is provided, in the form of a field effect transistor having a gate connection, a source connection and a drain connection, and which is provided in order to produce mixed signals from the carrier frequency and the modulation frequencies, with
the gate connection being connected to the fixed frequency generator,
the drain connection being connected to the second frequency generator,
the source connection being connected to earth,
a mixed signal being passed from the drain connection to an output,
- in which the mixer or a downstream frequency filter (BP) is provided in order to reduce the mixed signals that are produced to a predetermined frequency band,
- in which a transmitting and receiving device (TMIX, A) is provided,
- in which a reference device (SAW, RMIX) is provided, and is connected to the second frequency generator,
- in which an evaluation device (AE) is provided, and
- in which this evaluation device is connected to the transmitting and receiving device and to the reference device.

2. FMCW sensor having a fixed frequency generator (FFO) which is provided for producing a carrier frequency, and having a second frequency generator (VCO) which is provided for producing variable modulation frequencies,
- in which a mixer (AMIX) is provided, in the form of a field effect transistor having a gate connection, a source connection and a drain connection, and which is provided in order to produce mixed signals from the carrier frequency and the modulation frequencies, with
the drain connection being connected to the fixed frequency generator,
the gate connection being connected to the second frequency generator,
the source connection being connected to earth via a lowpass filter,
a mixed signal being passed from the source connection to an output,
- in which the mixer or a downstream frequency filter (BP) is provided in order to reduce the mixed signals that are produced to a predetermined frequency band,
- in which a transmitting and receiving device (TMIX, A) is provided,
- in which a reference device (SAW, RMIX) is provided, and is connected to the second frequency generator,
- in which an evaluation device (AE) is provided, and
- in which this evaluation device is connected to the transmitting and receiving device and to the reference device.

3. FMCW sensor according to one of Claims 1 and 2,
in which the field effect transistor is an HEMT (High Electron Mobility Transistor).

4. FMCW sensor according to one of Claims 1 to 3,
- in which the transmitting and receiving device is provided for monostatic operation and has a transmission mixer (TMIX) and an antenna (A),
- in which the transmission mixer has a hybrid coupler with a phase difference of 90° in the coupling arms, or a hybrid coupler with a phase difference of 180° in the coupling arms together with a circuit element which produces a phase shift of 90° and which is arranged in one of the coupling arms,
- in which the outputs (3, 4) of the hybrid coupler are terminated by nonlinear components,
- in which an input port (1) of the transmission mixer is connected directly or via further circuit elements to the mixer (AMIX, SSBMIX),
- in which the other input port (2) of the transmission mixer is connected to an antenna, and
- in which the evaluation device is connected to an output port of the transmission mixer.

5. FMCW sensor according to Claim 4,
in which the nonlinear components are field effect transistors, each of whose source connections is electrically conductively connected to the respective drain connection.

6. FMCW sensor according to one of Claims 1 to 5,
in which the reference device is a delay line, which is provided for producing a reference signal delayed in time with respect to the transmission signal.

7. FMCW sensor according to Claim 6,
in which the reference device has a surface acoustic wave component (SAW) and a further mixer (RMIX).

## Revendications

1. Détecteur à ondes entretenues à modulation de fréquence (FMCW) comprenant un générateur de fréquences fixes (FFO) prévu pour générer une fréquence porteuse et un deuxième générateur de fréquences (VCO) prévu pour générer des fréquences de modulation pouvant être modifiées,
- dans lequel se trouve un mélangeur (AMIX) sous la forme d'un transistor à effet de champ comprenant une borne de grille (gate), une borne de la source et une borne du drain, prévu pour générer des signaux mixtes au départ de la fréquence porteuse et des fréquences de modulation, la borne de grille (gate) étant connectée au générateur de fréquences fixes, la borne du drain étant connectée au deuxième générateur de fréquences, la borne de la source étant mise à la masse et un signal mixte étant acheminé de la borne du drain à une sortie;
- dans lequel il est prévu que le mélangeur réduit les signaux mixtes générés à une bande de fréquence donnée ou un filtre de fréquence monté en aval (BP) se trouve dans le montage pour servir aux mêmes fins;
- dans lequel se trouve un dispositif émetteur et récepteur (TMIX, A);
- dans lequel se trouve un dispositif de référence (SAW, RMIX) connecté au deuxième générateur de fréquences;
- dans lequel se trouve un dispositif d'analyse (AE) et
- dans lequel ledit dispositif d'analyse est connecté au dispositif émetteur et récepteur ainsi qu'au dispositif de référence.

2. Détecteur à ondes entretenues à modulation de fréquence (FMCW) comprenant un générateur de fréquences fixes (FFO) prévu pour générer une fréquence porteuse et un deuxième générateur de fréquences (VCO) prévu pour générer des fréquences de modulation pouvant être modifiées,
- dans lequel se trouve un mélangeur (AMIX) sous la forme d'un transistor à effet de champ comprenant une borne de grille (gate), une borne de la source et une borne du drain, prévu pour générer des signaux mixtes au départ de la fréquence porteuse et des fréquences de modulation, la bome du drain étant connectée au générateur de fréquences fixes, la borne de grille (gate) étant connectée au deuxième générateur de fréquences, la borne de la source étant mise à la masse via un filtre passe-bas et un signal mixte étant acheminé de la borne de la source à une sortie;
- dans lequel il est prévu que le mélangeur réduit les signaux mixtes générés à une bande de fréquence donnée ou un filtre de fréquence monté en aval (BP) se trouve dans le montage pour servir aux mêmes fins;
- dans lequel se trouve un dispositif émetteur et récepteur (TMIX, A);
- dans lequel se trouve un dispositif de référence (SAW, RMIX) connecté au deuxième générateur de fréquences;
- dans lequel se trouve un dispositif d'analyse (AE) et
- dans lequel ledit dispositif d'analyse est connecté au dispositif émetteur et récepteur ainsi qu'au dispositif de référence.

3. Détecteur à ondes entretenues à modulation de fréquence (FMCW) selon l'une des revendications 1 ou 2, dans lequel le transistor à effet de champ est un transistor HEMT (high electron mobility transistor).

4. Détecteur à ondes entretenues à modulation de fréquence (FMCW) selon l'une des revendications 1 à 3,
- dans lequel il est prévu que le dispositif émetteur et récepteur fonctionne en mode monostatique et comprend un mélangeur transmetteur (TMIX) et une antenne (A);
- dans lequel le mélangeur transmetteur comprend un coupleur hybride avec une différence de phase de 90° au niveau des bras de couplage ou un coupleur hybride avec une différence de phase de 180° réalisée au niveau des bras de couplage conjointement avec une composante du montage, laquelle provoque un déphasage de 90° et est placée dans l'un des bras de couplage;
- dans lequel les sorties (3, 4) du coupleur hybride sont fermées par des composantes non linéaires;
- dans lequel une grille d'entrée (1) du mélangeur transmetteur est connectée au mélangeur (AMIX, SSBMIX) directement ou via d'autres éléments du montage;
- dans lequel l'autre grille d'entrée (2) du mélangeur transmetteur est raccordée à une antenne et
- dans lequel le dispositif d'analyse est connecté à une grille de sortie du mélangeur transmetteur.

5. Détecteur à ondes entretenues à modulation de fréquence (FMCW) selon la revendication 4, dans lequel les composantes non linéaires sont des transistors à effet de champ dont la borne de la source est à chaque fois connectée à la borne du drain de manière à conduire électriquement.

6. Détecteur à ondes entretenues à modulation de fréquence (FMCW) selon l'une des revendications 1 à 5, dans lequel le dispositif de référence est une ligne de retard prévue pour générer un signal de ' référence retardé dans le temps par rapport à un signal d'émission.

7. Détecteur à ondes entretenues à modulation de fréquence (FMCW) selon la revendication 6, dans lequel le dispositif de référence comprend une composante à ondes de surface (SAW) et un autre mélangeur (RMIX).
